# EUROPEAN PATENT SPECIFICATION

(11) **EP 2 826 348 B1**
(45) Date of publication and mention of the grant of the patent: **04.12.2019**
(21) Application number: 12871555.4
(22) Date of filing: 12.03.2012
(51) Int. Cl.: H05K 7/20

(54) **RACK COOLING SYSTEM WITH A COOLING SECTION**
RACK-KÜHLSYSTEM MIT EINEM KÜHLABSCHNITT
SYSTÈME DE REFROIDISSEMENT DE BAIE AVEC UNE SECTION DE REFROIDISSEMENT

(43) Date of publication of application: 21.01.2015
(73) Proprietor: Hewlett Packard Enterprise Development LP, Houston, TX 77070 (US)
(72) Inventor: MOORE, David A., Houston, Texas 77070 (US); SABOTTA, Michael L., Houston, Texas 77070 (US); FRANZ, John P., Houston, Texas 77070 (US); CADER, Tahir, Liberty Lake, Washington 99019 (US)
(74) Representative: Iqbal, Md Mash-Hud
(86) International application number: PCT/US2012/028744
(87) International publication number: WO 2013/137849

(56) References cited:
- JP-A- H11 220 281
- KR-B1- 101 103 394
- US-A1- 2003 147 214
- US-A1- 2009 120 622
- US-B1- 6 305 180

## Description

### Background

Electronic equipment cooling practices may typically include air convection systems. In air convection systems fans are used to force moving air past heat producing electronic components to remove waste heat. Air convection systems are mainly used in situations where there is a low density of electronic components. However, as electronic components have grown more complex, air convection systems, in many instances, are insufficient to cool a high density of electronic components. Alternative cooling systems, such as liquid cooling systems, often require a high degree of maintenance and include a high degree of risk to the electronic components. Document US 6305180 discloses a system for cooling modular electronic units mounted in racks, each having a casing with an air inlet, an air outlet and a fan for cooling the contents of the unit. US 2009/120622 discloses a heat exchanger for water cooled network cabinets having two heat exchanger elements with separate cooling water connections which, accompanied by the formation of a space, are provided for the supply of exhaust air from the cabinet interior. A partition is adjustably placed in the space and in the case of a fault, e.g. if one heat exchanger element or a cooling circuit fails, the corresponding heat exchanger element is aerodynamically blocked with the aid of the partition. The entire exhaust air is cooled in the intact heat exchanger element and supplied to the cabinet interior, so that no interruption of operation is necessary. US2003/147214 discloses a device and a system for cooling heat generating electronics. The system has a plurality of cold plates which are adapted to transfer heat from a plurality of computer components to a cooling fluid. A supply line supplies the cooling fluid to and from these cold plates. The system also has a housing with one or more racks to support the computer component(s). The racks may also support the cold plates so that the cold plates are in thermal communication with at least one computer component.

### Brief Description of the Drawings

Figure 1A is a cross-sectional view taken along a cut line X-X in Figure 2 of an example of a frame with an air cooling system and a liquid cooling system in the cooling section and in the electronic equipment sections, along with the additions of a front and back plenum according to the present disclosure.
Figure 1B is a cross-sectional view taken along a cut line X-X in Figure 2 of an example of a frame with a liquid cooling system in the cooling section according to the present disclosure.
Figure 1C is a cross-sectional view taken along a cut line X-X in Figure 2 of an example of a frame with an air cooling system in the cooling section according to the present disclosure.
Figure 2 illustrates an example of a frame with a liquid cooling system in the cooling section according to the present disclosure.
Figure 3A illustrates an example of a frame with an enlarged cooling section relative to the example of the frame illustrated in Figure 2 according to the present disclosure.
Figure 3B illustrates an example of a frame with enlarged electronic equipment sections relative to the example of the frame illustrated in Figure 2 according to the present disclosure.
Figure 3C illustrates an example of a frame with a cooling section that is to the right of the electronic equipment sections according to the present disclosure.
Figure 4 illustrates an example of a configuration of frames according to the present disclosure.

### Detailed Description

Examples of the present disclosure may include methods and systems for cooling electronic components housed in a rack. An example system for cooling electronic components housed in a rack may include a frame including a number of dividers internal to the rack that define a plurality of sections within the rack. Moreover, an example system for cooling electronic components housed in a rack may further include a number of electronics sections including at least a first number of electronic components, and a number of cooling sections including at least a first cooling system that cools at least the first number of electronic components via heat transfer through the number of dividers.

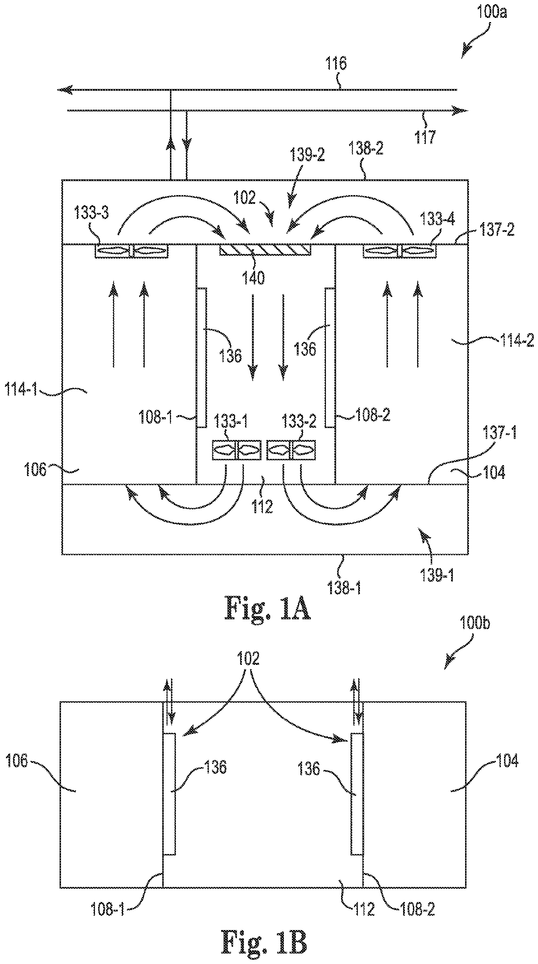

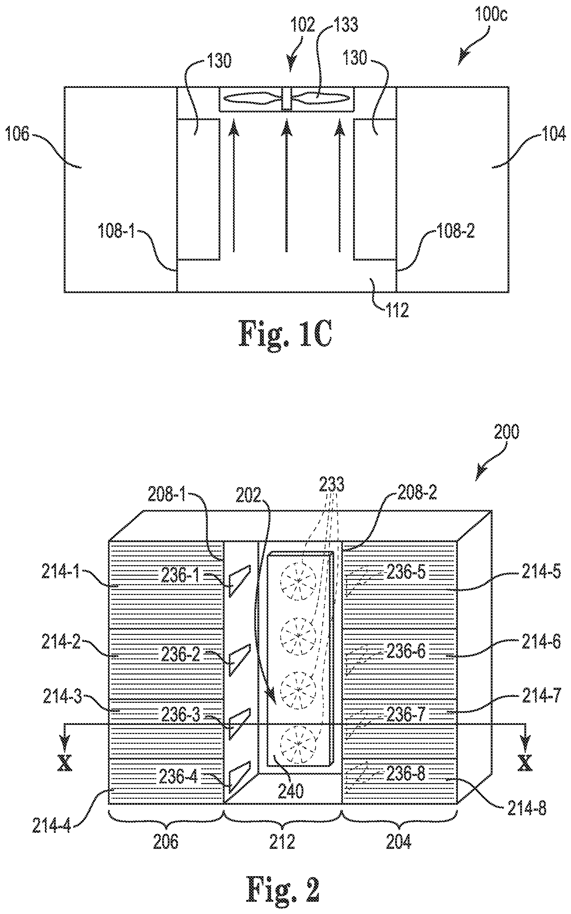

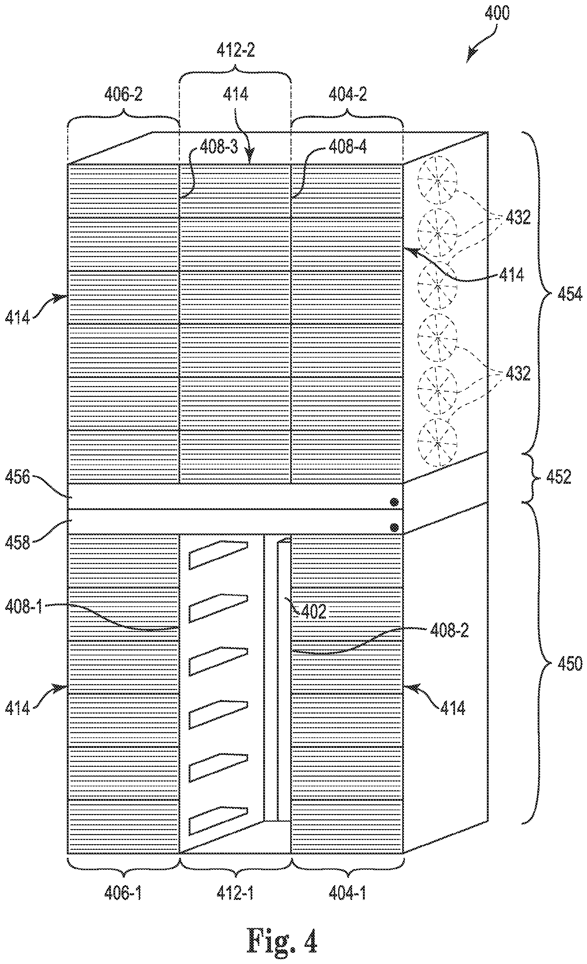

The figures herein follow a numbering convention in which the first digit or digits correspond to the drawing figure number and the remaining digits identify an element or component in the drawing. Similar elements or components between different figures may be identified by the use of similar digits. For example, 112 may reference element "12" in Figure 1, and a similar element may be referenced as 412 in Figure 4.

As used herein, "a" or "a number of" something can refer to one or more such things. For example, "a number of widgets" can refer to one or more widgets.

The cooling needs of rack mounted electronic components vary greatly depending on the function of the equipment. High Performance Computing (HPC) applications may have a higher power density and as a result a higher heat output than non-HPC applications. However, HPC applications and non-HPC applications are typically cooled similarly by air cooling systems. In air cooling systems, fans move air from the front of a rack to the back of a rack according to some previous approaches. Fans may create undesirable noise disturbance in equipment with high power density. Heat extraction by air cooling systems can create large volumes of heated air. The heated air can be cooled by HVAC equipment according to some previous approaches which can create a burden on the HVAC equipment and incur operational expenses. This HVAC equipment refers to the heating, ventilation, and air conditioning systems in a building. In many instances, air cooling systems are insufficient to cool HPC applications.

In an example of the present disclosure, a rack and the cooling systems that are in the rack can be configured to the cooling needs of electronic components that it houses. Additionally, the different sections within a rack can be configured to fit the space needs and cooling needs of electronic components housed in the rack. The rack described in the present disclosure can be combined in different configurations with traditional racks that house electronic components. This can provide greater flexibility in cooling electronic components and may house a higher density of electronic components (e.g., HPC applications) than some previous approaches. Furthermore, a number of embodiments may reduce operating expenses and noise disturbance associated with a rack. The invention is defined by features of claim 1. Further embodiments are defined in the dependent claims.

Figure 1A is a cross-sectional view taken along a cut line X-X in Figure 2 of an example of a frame 100a with an air cooling system and a liquid cooling system in the cooling section and in the electronic equipment sections, with additions of a front and back plenum, according to the present disclosure. In some examples of the present disclosure, a cooling system can include any number of cooling systems in any number of configurations. The frame 100a can have a front door 138-1 offset from a front inner panel 137-1 and a back door 138-2 offset from a back inner panel 137-2 to create a front plenum 139-1 and a back plenum 139-2 for a closed loop air cooling system. Closed loop refers to air circulation that remains internal to the frame 100a. The front door 138-1 and the back door 138-2 can be opened or fixed in a closed position. The front inner panel 137-1 and the back inner panel 137-2 can be air permeable (e.g., metal mesh, vented metal, honeycomb shaped composite, among other air permeable panels).

In some examples of the present disclosure, the frame 100a can have a section 106 that can house a first number of electronic components, a section 104 that can house a second number of electronic components, and a section 112 that can house a cooling system 102. Electronic components can include server devices, storage devices, and other computation centered devices although electronic components are not limited to such devices. In some examples, the electronic components can be blades, such as server blades. Each of the sections in frame 100a can be distinguished from the other sections by a plurality of dividers. For example, a first divider 108-1 can distinguish section 106 from section 112. Additionally, a second divider 108-2 can distinguish section 104 from section 112.

In an example of the present disclosure, a cooling system can cool electronic components through the plurality of dividers. For example, cooling system 102 can cool electronic components 114-1 through divider 108-1. Moreover, cooling system 102 can cool electronic components 114-2 through divider 108-2. In an example, the heat produced by electronic components 114-1 can be directed towards divider 108-1. The heat produced by electronic components 114-2 can be directed towards divider 108-2. The dividers, e.g., 108-1 and 108-2, can function as conductive cooling receivers. That is, heat brought to the dividers can be removed from section 106 and section 104 into the dividers by conduction and the heat can then be removed from the divider by liquid circulation.

Divider 108-1 and divider 108-2 can extend from the back inner panel 137-2 of frame 100a to the front inner panel 137-1 of frame 100a without extending to the front door 138-1 or the back door 138-2. The front inner panel 137-1 and the back inner panel 137-2 can be continuous across section 104, section 112, and section 106 or sectional such that each panel includes multiple portions interconnected, for example, at the divider 108-1 and the divider 108-2. Front inner panel 137-1 and back inner panel 137-2 can have the same or different configurations. Other configurations for the front inner panel 137-1 and back inner panel 137-2 can be employed without departing from the scope of the present disclosure.

The cooling system 102, e.g., closed loop air cooling system and liquid cooling system, can include a number of fans (e.g., fan 133-1, fan 133-2, fan 133-3, and fan 133-4), an air-to-liquid heat exchanger 140, and/or a number of heat receiving structures 136. Examples are not limited to including a particular number of fans, air-to-liquid heat exchangers, and/or a number of heat receiving structures 136. In an example of the present disclosure, the air-to-liquid heat exchanger 140 can be connected (not shown) to a cool liquid input 117 and a warm liquid output 116 while the heat receiving structures 136 can also be connected (not shown) to a cool liquid input 117 and a warm liquid output 116. In some examples of the present disclosure, the air-to-liquid heat exchanger 140 can be connected (not shown) to a cool liquid input 117 and a warm liquid output 116 while the heat receiving structures 136 can receive (not shown) liquid from the output (not shown) of the air-to-liquid heat exchanger 140 and can be connected (not shown) to a warm liquid output 116. The cool liquid input 117 and the warm liquid output 116 can be housed in a source which can be located at the rack level, CDU (Coolant Distribution Unit) level, and/or the facility level. An air-to-liquid heat exchanger 140 can be air permeable. An air-to-liquid heat exchanger 140 can remove heat from the air by moving heat from the air that is circulated within frame 100a to a liquid in the air-to-liquid heat exchanger 140.

The fans 133 can circulate air from the back of section 112 to the front of section 112, out of section 112 into the front plenum 139-1, out of the front plenum 139-1 through section 104 and section 106, into the back plenum 139-2, and then through the air-to-liquid heat exchanger 140 back into section 112. The air can be heated by the electronic components while in section 104 and section 106. The air-to-liquid heat exchanger 140 can cool air such that the re-circulated air can be cool when it reaches the front plenum 139-1. The front door 138-1 can help to re-direct the cool air from the front of section 112 to the front of section 104 and section 106. The back door 138-2 can help to re-direct the warm air from the back of section 106 and section 104 to the back of section 112.

Figure 1B is a cross-sectional view taken along a cut line X-X in Figure 2 of an example of a frame with a liquid cooling system in the cooling section according to the present disclosure. In a number of examples of the present disclosure, a frame 100b can have a section 106 that can house a number of electronic components, a section 104 that can house a number of electronic components, and a cooling section 112 that can house a cooling system 102. In an example of the present disclosure, cooling system 102 can include a liquid cooling system (e.g., a conductive cooling system such as a dry disconnect cooling system). A liquid cooling system can include a number of heat receiving structures 136 that can be mounted on divider 108-1 and divider 108-2. The heat receiving structures 136 can be analogous to the heat receiving structures 136 illustrated in Figure 1A. The heat receiving structures 136 can include a shell with an internal compartment which holds liquid. Liquid can be circulated through the internal structure to cool the heat receiving structure. The liquid cooling system can circulate cool liquid from a source that can be external to frame 100b. The cool liquid can circulate from the main compartment to a number of heat receiving structures 136. The heat receiving structures 136 can cool a number of electronic components through divider 108-1 and divider 108-2 by moving the heat from divider 108-1 and divider 108-2 to the liquid. The warm liquid can then be circulated from the heat receiving structures 136 to the source where the liquid can be cooled, (e.g., external cooling system). The source, (e.g., external cooling system) can cool a warm liquid through the use of fans or other cooling mechanisms.

Figure 1C is a cross-sectional view taken along a cut line X-X in Figure 2 of an example of a frame with an air cooling system in the cooling section according to the present disclosure. For example, frame 100c can include a section 106 that can house a number of electronic components, a section 104 that can house a number of electronic components, and a cooling section 112 that can house a cooling system 102. Furthermore, frame 100c can include a number of dividers such as divider 108-1 and divider 108-2. Divider 108-1 can divide section 106 from section 112. Divider 108-2 can divide section 104 from section 112.

A cooling system 102 can include any number of cooling systems in any number of configurations. In an example of present disclosure, a cooling system 102 can include an air cooling system. In cooling system 102, a fan 133 can be located in the back of the frame 100c. The cooling system 102 can circulate air from the front of section 112 to the back of section 112. Although cooling system 102 can circulate air in a number of directions. For example, cooling system 102 can circulate air from the back of section 112 to the front of section 112. In a number of examples, a fan can be located on any surface in a section within a frame. For example, a fan can be located on the front panel of section 112, the top panel of section 112, or any other panel within section 112.

In a number of examples, air circulation can cool a number of dividers. For example, the fan 133 in section 112 can circulate air within the section 112. The circulation of air can cool a number of dividers. For example, the fan 133, in cooling system 102, can circulate air which can cool divider 108-1 and divider 108-2. The air circulation created by the cooling system 102 can create a temperature difference between section 112 and section 106 and section 104 and section 112. Heat can travel from one section to another section when there is a temperature difference between two sections. For example, heat can travel from section 106 through divider 108-1 and into section 112 and heat can travel from section 104 through divider 108-2 and into section 112.

In a number of examples, the dividers can function as a radiator. That is, in a number of examples, the dividers can function to release heat from one section to another section. Dividers can include materials that efficiently disperse heat. Such materials can include GrafTech (e.g., a graphite material) although a divider can be constructed from any number of materials and is not limited to GrafTech. A divider can also include portions of a divider that efficiently disperses heat. For example, divider 108-1 and divider 108-2 can include a number of heat blocks 130 of a material that efficiently disperses heat. A heat block can include a square or a rectangular piece of material with fins and ridges to increase the surface of the heat block although heat blocks can include other shapes. Materials used in heat blocks can include aluminum and copper although a heat block can be made from other materials. Aluminum and copper can be used because the heat conductivity of metal is greater than the heat conductivity of air. Efficiently dispersing heat refers to the selection of materials with a high level of heat conductivity as compared to the heat conductivity of other materials used in the construction of a frame. In an example of the present disclosure, a number of heat blocks 130 can be built into divider 108-1 and divider 108-2. That is, divider 108-1 and a group of a number of heat blocks 130 can be a single unit and divider 108-2 and a group of a number of heat blocks 130 can be single unit. Likewise, in a number of examples of the present disclosure, a number of heat blocks 130 can be attached to divider 108-1 and divider 108-2. That is, a number of heat blocks 130, divider 108-1 and divider 108-2 can be separate units.

Figure 2 illustrates an example of a frame with a liquid cooling system in the cooling section according to the present disclosure. In an example of the present disclosure, a frame 200 can include a plurality of rack mounting sections to house electronic components or other types of heat producing equipment, although a frame is not limited to housing the stated types of equipment. For example, a frame 200 can include a standard 19 inch rack. A standard 19 inch rack can include a front that is 19 inches wide which can include the edges to which electronic components are mounted. In another example, a frame 200 can include a front that is 23 inches wide. Examples used herein are illustrative and not limiting and can include a variety of front panel measurements. In an example of the present disclosure, a frame 200 can be 42 units (U) tall, although a frame is not limited to a height of 42 units. A unit may be considered one rack unit, which is an industry standard. In some applications a unit (U) is equal to 1.75 inches.

Frame 200 can have a front, a back, a top, and a bottom. The front of frame 200 can include the front of section 206, the front of section 204, and the front of section 212. The front of frame 200 can include an opening through which electronic components can be installed in frame 200. Such that, electronic components can be installed from the front of frame 200 towards the back of frame 200. Furthermore, the frame 200 can have a front door (not shown) offset from a front inner panel (not shown) and a back door (not shown) offset from a back inner panel (not shown) to create a front plenum (not shown) and a back plenum (not shown) for a closed loop air cooling system. The front door, front inner panel, back door, back inner panel, front plenum, and back plenum can be analogous to the front door 138-1, front inner panel 137-1, back door 138-2, back inner panel 137-2, front plenum 139-1, and back plenum 139-2 illustrated in Figure 1A, respectively.

In some examples of the present disclosure, a frame 200 can include a number of dividers. Dividers can include a continuous solid panel. For example, divider 208-1 and divider 208-2 can be continuous solid panels. In a number of examples of the present disclosure, dividers can be attached to the frame 200. For example, a first divider 208-1 and second divider 208-2 can be attached to the top of frame 200 and to the bottom of the frame 200. Likewise, divider 208-1 and divider 208-2 can be attached to the front of frame 200 and to the back of frame 200. In some embodiments, a first divider and a second divider can partially extend from the front of a frame to the back of a frame. That is, a first divider can extend from the front of a frame to the back of the frame and not touch the front of the frame or the back of the frame.

In Figure 2 a frame 200 can include a first section 206 that can house electronic components, a second section 204 that can house electronic components, and a third section 212 that can house a cooling system 202. Embodiments, however, are not limited to a particular number of sections. In an example of Figure 2, section 206 can be divided from section 212 by divider 208-1 and section 204 can be divided from section 212 by divider 208-2. Section 206 and section 204 can include electronic components 214-1, electronic components 214-2, electronic components 214-3, and electronic components 214-4, electronic components 214-5, electronic components 214-6, electronic components 214-7, and electronic components 214-8 (referred to generally as electronic components 214). The electronic components 214 can produce heat at different rate. For example, electronic components 214-1 can produce heat at a higher rate then electronic components 214-2.

In an example of the present disclosure, section 212 can house multiple cooling sub-systems. For example, section 212 can house a cooling system 202 that can include an air-to-liquid heat exchanger 140 and heat receiving structure 236-1, heat receiving structure 236-2, heat receiving structure 236-3, heat receiving structure 236-4, heat receiving structure 236-5, heat receiving structure 236-6, heat receiving structure 236-7, and heat receiving structure 236-8 (referred to generally as heat receiving structures 236). The air-to-liquid heat exchanger 240 can be analogous to the air-to-liquid heat exchanger 140 illustrated in Figure 1A. The heat receiving structures 236 can be analogous to the heat receiving structures 136 illustrated in Figure 1B.

Heat receiving structures 236 can transfer heat from section 206 and section 204 into a liquid that is circulated from the air-to-liquid heat exchanger 240 into heat receiving structures 236 and out of the frame 200. Heat receiving structures 236 can be configured to transfer heat at different rates. As mentioned above, electronic components can produce heat at different rates. Heat receiving structure 236-1 can be configured to transfer heat at a rate that meets the cooling needs of electronic components 214-1, heat receiving structure 236-2 can be configured to transfer heat at a rate that meets the cooling needs of electronic components 214-2, heat receiving structure 236-3 can be configured to transfer heat at a rate that meets the cooling needs of electronic components 214-3, heat receiving structure 236-4 can be configured to transfer heat at a rate that meets the cooling needs of electronic components 214-4, heat receiving structure 236-5 can be configured to transfer heat at a rate that meets the cooling needs of electronic components 214-5, heat receiving structure 236-6 can be configured to transfer heat at a rate that meets the cooling needs of electronic components 214-6, heat receiving structure 236-7 can be configured to transfer heat at a rate that meets the cooling needs of electronic components 214-7, and heat receiving structure 236-8 can be configured to transfer heat at a rate that meets the cooling needs of electronic components 214-8.

A cooling system 202 can include a number of fans 233 in section 212 and a number of fans (not shown) in section 206 and section 204. The number of fans 233 can circulate air from the back of section 212 to the front of section 212, out of section 212 and into the front plenum, out of the front plenum through section 204 and section 206, into the back plenum, and then through the air-to-liquid heat exchanger 240 back into section 212.

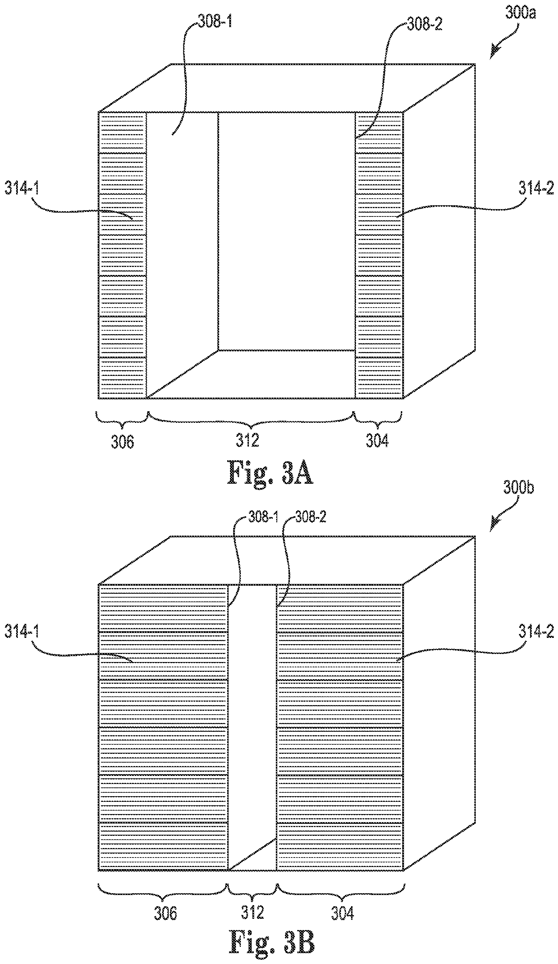

Figure 3A illustrates an example of a frame with an enlarged cooling section 312 relative to the example of the frame illustrated in Figure 2 according to the present disclosure. Other than the layout of sections, the frame 300a can be analogous to the frame 200 illustrated in Figure 2. In Figure 3A, frame 300a includes a section 306 that can house electronic components 314-1, a section 304 that can house electronic components 314-2, and a section 312 that can house a cooling system (not shown). Section 306 can be divided from section 312 by divider 308-1 and section 304 can be divided from section 312 by divider 308-2. The dividers, e.g., 308-1 and 308-2 are components that can be reconfigured quickly to accommodate a change in design rule to the electronic components as called out in the claims. Dividers internal to a frame can move to increase the volume of some sections and to decrease the volume of other sections. For example, divider 308-1 can be moved to the left, as compared to the position of divider 208-1 in frame 200 in Figure 2. Moving divider 308-1 to the left can increase the volume of section 312 and decrease the volume of section 306, according to an arbitrary partial rack section use 306. That is, the volume of section 306 may be decreased in examples in which the electronic components 314-1 need less space. Divider 308-2 can also be moved to the right, as compared to the position of divider 208-2 within frame 200. Moving divider 308-2 to the right can decrease the volume of section 304 and increase the volume of section 312. The volume of section 304 may be decreased in examples in which the electronic components 314-2 need less space. The frame 300a can therefore support multiple attachment points for the divider 308-1 and the divider 308-2. The positioning of the divider 308-1 can define the section 306 (e.g., in relation to other portions of the frame 300a) and the positioning of divider 308-2 can define the section 304. The relative positioning of divider 308-1 and divider 308-2 can define the section 312.

Figure 3B illustrates an example of a frame with enlarged electronic equipment relative to the example of the frame illustrated in Figure 2 according to the present disclosure. In Figure 3B, frame 300b includes a section 306 that can house electronic components 314-1, a section 304 that can house electronic components 314-2, and section 312 that can house a cooling system (not shown). Section 306 can be divided from section 312 by divider 308-1 and section 304 can be divided from section 312 by divider 308-2. Dividers internal to a frame can move to increase the volume of some sections and decrease the volume of other sections. For example, divider 308-1 can be moved to the right, as compared to the position of divider 208-1 within frame 200 in Figure 2. Moving divider 308-1 to the right can decrease the volume of section 312 and increase the volume of section 306. The volume of section 306 may be increased in examples in which the electronic components 314-1 need more space. Divider 308-2 can also be moved to the left, as compared to the position of divider 208-2 within frame 200. Moving divider 308-2 to the left can increase the volume of section 304 and decrease the volume of section 312. The volume of section 304 may be increased in examples in which the electronic components 314-2 need more space.

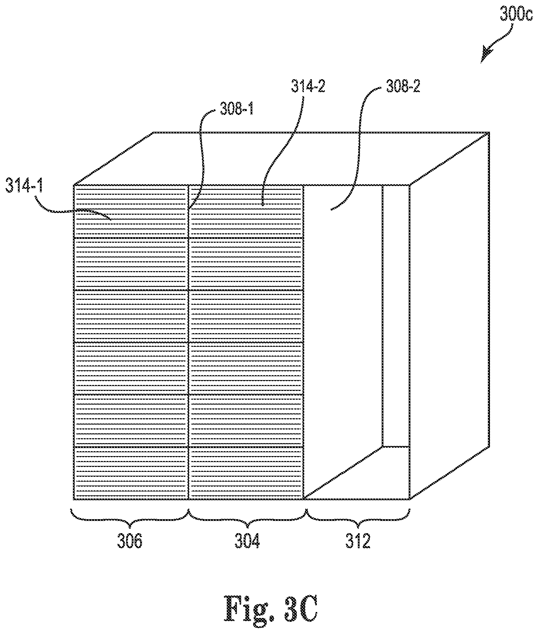

Figure 3C illustrates an example of a frame with a cooling section that is to the right of the electronic equipment sections according to the present disclosure. In an example of the present disclosure, frame 300c can include a section 306 that can house electronic components 314-1, a section 304 that can house electronic components 314-2, and section 312 that can house a cooling system, as described above. In some examples of the present disclosure, a cooling section can be between two sections that house electronic components. In another example of the present disclosure, a cooling section can be located to the right of the two sections that can house electronic components, as shown in Figure 3C. For example, section 306 can be divided from section 304 by divider 308-1, and section 312 can be divided from section 304 by divider 308-2 such that section 304 and section 306 are next to each other and section 312 is to the right of section 304 and 306. In some examples of the present disclosure, section 306 and section 304 can be one continuous section without a divider 308-1. In another example of the present disclosure, a cooling section can be located to the left of the two sections that can house electronic components.

Figure 4 illustrates an example of a configuration of frames according to at least one embodiment of the present disclosure. In the example of Figure 4, frames can be combined in a number of configurations to meet the cooling needs of a number of electronic components. For example, frame structure 400 can include a first frame 450, a second frame 452 and a third frame 454. Frame 450 can include a number of sections. For example frame 450 can include section 406-1 that can house electronic components 414, section 404-1 that can house electronic components 414, and section 412-1 that can house a cooling system 402. Furthermore, section 406-1 can be divided from section 412-1 by divider 408-1 and section 404-1 can be divided from section 412-1 by divider 408-2.

Frame 452 can be used to house rack infrastructure equipment although frame 452 is not limited to such. Frame infrastructure equipment can include network equipment 456 and power equipment 458. Network equipment 456 can provide networking capabilities to frame 450, frame 452, and frame 454. For example, networking equipment 456 can provide networking capabilities to electronic components 414. Additionally, networking equipment 456 can provide networking capabilities to cooling system 402. Power equipment 458 can provide power to frame 450, frame 452, and frame 454. For example, power equipment 458 can provide power to electronic components 414 and cooling system 402.

Frame 454 can include a number of sections that can house electronic components. For example, frame 454 can include section 404-2 that can house electronic components 414, section 406-2 that can house electronic components 414, and section 412-2 that can house electronic components 414. Section 406-2 can be divided from section 412-2 by divider 408-3 and section 404-2 can be divided from section 412-2 by divider 408-4. Frame 454 can include a cooling system. For example, frame 454 can include an air cooling system 432 which can include a number of fans (not all fans are illustrated) in section 404-2, section 412-2, and section 406-2. The fans can be located at the back panel of frame 454. The number of fans can circulate air from the front of frame 454 to the back of frame 454.

In some examples of the present disclosure, a cooling system in a frame can cool a number of sections in a different frame. For example, a cooling system 402 in section 412-1 in frame 450 can cool frame infrastructure equipment (e.g., network equipment 456 and power equipment 458) in frame 452 and section 404-2, section 406-2, and section 412-2 in frame 454.

In a number of examples of the present disclosure, frames can be configured to support other frames. For example, frame structure 400 can be configured such that frame 450 can supports frame 452 and frame 452 can support frame 454. In an example of the present disclosure, frame 454 can support frame 452 and frame 452 can support frame 450.

Furthermore, frame 450, frame 452, and frame 454 can include a front door (not shown) offset from a front inner panel (not shown) and a back door (not shown) offset from a back inner panel (not shown) to create a front plenum (not shown) and a back plenum (not shown) for a closed loop air cooling system. That is, a front inner panel can include a panel that extends over the front of section 406-1, section 406-2, section 412-1, section 412-2, section 404-1, section 404-2, network equipment 456, and power equipment 458. A back inner panel can include a panel that extends over the back of section 406-1, section 406-2, section 412-1, section 412-2, section 404-1, section 404-2, network equipment 456, and power equipment 458. In a number of examples of the present disclosure, a front panel and a back panel can extend over a portion of frame 450, frame 452, and frame 454.

Additionally, a closed loop air cooling system can include cooling system 402, and air cooling system 432. In some examples of the present disclosure, a closed loop air cooling system can cool a number of sections in a number of frames. For example, closed loop air cooling system can cool section 406-1, section 406-2, section 412-1, section 412-2, section 404-1, section 404-2, networking equipment 456, and power equipment 458. In an example of the present disclosure, a closed loop air cooling system can cool a number of sections in a single frame. For example, closed loop air cooling system can cool section 406-1, section 412-1, and section 404-1 in frame 450.

In a number of examples of the present disclosure, frame 450, frame 452, and frame 454 can be configured to be horizontally next to each other. For example, frame 450 can be horizontally next to frame 452 and frame 452 can be horizontally next to frame 454. A number of frame configurations can be achieved in a number of examples of the present disclosure and frame configurations should not be limited to the examples listed herein.

## Claims

1. A rack cooling system, comprising:
a frame including a number of dividers (108-1,108-2) internal to the rack that define a plurality of sections within the rack, wherein the plurality of sections includes:
a number of electronics sections (104,106) including at least a first number of electronic components; and
the rack cooling system **characterised by**
a number of cooling sections (112) including at least a first cooling system configured to cool at least the first number of electronic components via heat transfer through the number of dividers;
wherein the number of dividers are movable to increase a volume of some sections of the plurality of sections and to decrease a volume of other sections of the plurality of sections,
and wherein the number of dividers are configured to function as conductive cooling receivers that receive heat from the electronics sections and conduct the received heat away from the dividers.

2. The system of claim 1, wherein the first cooling system includes at least one of an air to water cooling system and a dry disconnect cooling system.

3. The system of claim 1, wherein the number of dividers includes:
a first divider (108-1) that defines a first electronics section (106) from the number of electronics sections (104,106) including the first number of electronic components (114-1);
a second divider (108-2) that defines a second electronics section (104) from the number of electronics sections (104,106) including a second number of electronic components (114-2); and
a first cooling section (112) from the number of cooling sections, between the first electronics section (106) and the second electronics section (104), including the first cooling system configured to cool the first number of electronic components (114-1) and the second number of electronic components (114-2) via heat transfer through the first divider (108-1) and the second divider (108-2).

4. The system of claim 3, wherein a first number of cooling receivers are mounted on the first divider (108-1) and a second number of cooling receivers are mounted on the second divider (108-2) and wherein the first number of cooling receivers are cooled by moving liquid through the first cooling section (112) and the second number of cooling receivers are cooled by moving liquid through the first cooling section (112).

5. The system of claim 3, wherein a first number of cooling receivers are mounted on the first divider (108-1) and a second number of cooling receivers are mounted on the second divider (108-2) and wherein the first number of cooling receivers are cooled by moving air through the first cooling section (112) and the second number of cooling receivers are cooled by moving air through the first cooling section (112).

6. The system of claim 3, wherein a first number of cooling receivers are mounted on the first divider (108-1) and a second number of cooling receivers are mounted on the second divider (108-2) and wherein a first group of the first number of cooling receivers and a first group of the second number of cooling receivers are cooled by moving air through a first portion of the first cooling section (112) and a second group of the first number of cooling receivers and a second group of the second number of cooling receivers are cooled by moving liquid through a second portion of the first cooling section (112).

7. The system of claim 3, wherein the first electronics sections (106) includes a second cooling system and the second electronics section (104) includes a third cooling system wherein the second cooling system and the third cooling system are configured to circulate air into the first cooling section (112) and the first cooling system is configured to circulate air into the first electronics section (106) and the second electronics section (104).

8. The system of claim 3, wherein the frame is configured to support a plurality of positions of at least one of the number of dividers (108-1,108-2) to adjust a volume of at least one of the number of electronics sections (106, 104) and the number of cooling sections (112).

9. The system of claim 3, wherein the first cooling section (112) is configured to support different types of cooling systems to adjust cooling capability according to cooling needs of the first number of electronic components (114-1) and the second number of electronic components (114-2).

10. The system of claim 3, further comprised of:
a front (137-1) of the frame through which the first number of electronic components (114-1) and the second number of electronic components (114-2) are inserted into the frame, wherein the front (137-1) of the frame includes a front of the first electronics section (114-1), a front of the second electronics section (114-2), and a front of the first cooling section (112);
a back (138-2) of the frame, wherein the first divider (108-1) and the second divider (108-2) extend from the front (137-1) of the frame to the back (137-2) of the frame;
a top of the frame;
a floor of the frame, wherein the first divider (108-1) and the second divider (108-2) are composed of solid panels that extend from the top of the frame to the floor of the frame;
a front door (138-1) of the frame offset from the front (137-1) of the frame; and
a back door (138-2) of the frame offset from the back (137-2) of the frame.

11. A method (102) for cooling electronic components housed in an electronics rack, comprising:
providing a frame including a plurality of dividers (108-1,108-2) internal to the electronic rack that define a plurality of sections within the electronic rack, wherein the frame includes a front (137-1) of the frame, a back (137-2) of the frame, a top of the frame, and a floor of the frame;
defining a first section (106) with a first one (108-1) of the plurality of dividers to house a first number of electronic components (114-1);
defining a second section (104) with a second one of the plurality of dividers (108-1,108-2) to house a second number of electronic components, wherein:
the first one of the plurality of dividers and the second one of the plurality of dividers (108-1,108-2) are attached to the top of the frame and to the floor of the frame and the first one of the plurality of dividers and the second one of the plurality of dividers (108-1,108-2) do not extend from the front of the frame to the back of the frame;
defining a third section, between the first section and the second section, including a number of cooling systems to cool the first number of electronic components and the second number of electronic components via heat transfer through the first one of the plurality of dividers (108-1) and the second one of the plurality of dividers (108-2), wherein:
the front of the frame includes a front of the first section, a front of the second section, and a front of the third section; and
the third section supports different types of cooling systems to adjust cooling capability according to cooling needs of the first number of electronic components and the second number of electronic components;
wherein the plurality of dividers are movable to increase a volume of some sections of the first, second and third sections and to reduce a volume of other sections of the first, second and third of sections
and wherein the plurality of dividers are configured to function as conductive cooling receivers that receive heat from the electronics sections and conduct the received heat away from the dividers.

## Patentansprüche

1. Rack-Kühlsystem, umfassend:
einen Rahmen, der eine Anzahl von Trennwänden (108-1, 108-2) innerhalb des Racks beinhaltet, die eine Vielzahl von Abschnitten innerhalb des Racks definieren, wobei die Vielzahl von Abschnitten Folgendes beinhaltet:
eine Anzahl von Elektronikabschnitten (104, 106), die mindestens eine erste Anzahl von elektronischen Komponenten beinhalten; und
wobei das Rack-Kühlsystem durch eine Anzahl von Kühlabschnitten (112)
gekennzeichnet ist, die mindestens ein erstes Kühlsystem beinhalten, das dazu
konfiguriert ist, mindestens die erste Anzahl von elektronischen Komponenten über Wärmeübertragung durch die Anzahl von Trennwänden zu kühlen;
wobei die Anzahl von Trennwänden beweglich ist, um ein Volumen von einigen Abschnitten der Vielzahl von Abschnitten zu vergrößern und ein Volumen von anderen Abschnitten der Vielzahl von Abschnitten zu verkleinern, und wobei die Anzahl von Trennwänden dazu konfiguriert ist, als leitfähige Kühlungsempfänger zu fungieren, die Wärme von den Elektronikabschnitten aufnehmen und die aufgenommene Wärme von den Trennwänden wegleiten.

2. System nach Anspruch 1, wobei das erste Kühlsystem ein Luft-Wasser-Kühlsystem und/oder ein Trockentrennkühlsystem beinhaltet.

3. System nach Anspruch 1, wobei die Anzahl von Trennwänden Folgendes beinhaltet:
eine erste Trennwand (108-1), die einen ersten Elektronikabschnitt (106) aus der Anzahl von Elektronikabschnitten (104, 106) definiert, die die erste Anzahl von elektronischen Komponenten (114-1) beinhalten;
eine zweite Trennwand (108-2), die einen zweiten Elektronikabschnitt (104) aus der Anzahl von Elektronikabschnitten (104, 106) definiert, die eine zweite Anzahl von elektronischen Komponenten (114-2) beinhalten; und
einen ersten Kühlabschnitt (112) aus der Anzahl von Kühlabschnitten zwischen dem ersten Elektronikabschnitt (106) und dem zweiten Elektronikabschnitt (104), einschließlich des ersten Kühlsystems, das dazu konfiguriert ist, die erste Anzahl von elektronischen Komponenten (114-1) und die zweite Anzahl von elektronischen Komponenten (114-2) über Wärmeübertragung durch die erste Trennwand (108-1) und die zweite Trennwand (108-2) zu kühlen.

4. System nach Anspruch 3, wobei eine erste Anzahl von Kühlungsempfängern auf der ersten Trennwand (108-1) und eine zweite Anzahl von Kühlungsempfängern auf der zweiten Trennwand (108-2) montiert sind und wobei die erste Anzahl von Kühlungsempfängern durch Bewegen von Flüssigkeit durch den ersten Kühlabschnitt (112) und die zweite Anzahl von Kühlungsempfängern durch Bewegen von Flüssigkeit durch den ersten Kühlabschnitt (112) gekühlt werden.

5. System nach Anspruch 3, wobei eine erste Anzahl von Kühlungsempfängern auf der ersten Trennwand (108-1) und eine zweite Anzahl von Kühlungsempfängern auf der zweiten Trennwand (108-2) montiert sind und wobei die erste Anzahl von Kühlungsempfängern durch Bewegen von Luft durch den ersten Kühlabschnitt (112) und die zweite Anzahl von Kühlungsempfängern durch Bewegen von Luft durch den ersten Kühlabschnitt (112) gekühlt werden.

6. System nach Anspruch 3, wobei eine erste Anzahl von Kühlungsempfängern auf der ersten Trennwand (108-1) und eine zweite Anzahl von Kühlungsempfängern auf der zweiten Trennwand (108-2) montiert sind und wobei eine erste Gruppe der ersten Anzahl von Kühlungsempfängern und eine erste Gruppe der zweiten Anzahl von Kühlungsempfängern durch Bewegen von Luft durch einen ersten Teilabschnitt des ersten Kühlabschnitts (112) und eine zweite Gruppe der ersten Anzahl von Kühlungsempfängern und eine zweite Gruppe der zweiten Anzahl von Kühlungsempfängern durch Bewegen von Flüssigkeit durch einen zweiten Teilabschnitt des ersten Kühlabschnitts (112) gekühlt werden.

7. System nach Anspruch 3, wobei die ersten Elektronikabschnitte (106) ein zweites Kühlsystem und der zweite Elektronikabschnitt (104) ein drittes Kühlsystem beinhalten, wobei das zweite Kühlsystem und das dritte Kühlsystem dazu konfiguriert sind, Luft in den ersten Kühlabschnitt (112) zu zirkulieren, und das erste Kühlsystem dazu konfiguriert ist, Luft in den ersten Elektronikabschnitt (106) und den zweiten Elektronikabschnitt (104) zu zirkulieren.

8. System nach Anspruch 3, wobei der Rahmen dazu konfiguriert ist, eine Vielzahl von Stellungen von mindestens einer der Anzahl von Trennwänden (108-1, 108-2) zu tragen, um ein Volumen von mindestens einem der Anzahl von Elektronikabschnitten (106, 104) und der Anzahl von Kühlabschnitten (112) einzustellen.

9. System nach Anspruch 3, wobei der erste Kühlabschnitt (112) dazu konfiguriert ist, verschiedene Arten von Kühlsystemen zu tragen, um die Kühlleistung entsprechend dem Kühlbedarf der ersten Anzahl von elektronischen Komponenten (114-1) und der zweiten Anzahl von elektronischen Komponenten (114-2) einzustellen.

10. System nach Anspruch 3, das ferner Folgendes umfasst:
eine Vorderseite (137-1) des Rahmens, durch die die erste Anzahl von elektronischen Komponenten (114-1) und die zweite Anzahl von elektronischen Komponenten (114-2) in den Rahmen eingesetzt werden, wobei die Vorderseite (137-1) des Rahmens eine Vorderseite des ersten Elektronikabschnitts (114-1), eine Vorderseite des zweiten Elektronikabschnitts (114-2) und eine Vorderseite des ersten Kühlabschnitts (112) beinhaltet;
eine Rückseite (138-2) des Rahmens, wobei sich die erste Trennwand (108-1) und die zweite Trennwand (108-2) von der Vorderseite (137-1) des Rahmens bis zur Rückseite (137-2) des Rahmens erstrecken;
eine Oberseite des Rahmens;
einen Boden des Rahmens, wobei die erste Trennwand (108-1) und die zweite Trennwand (108-2) aus massiven Platten bestehen, die sich von der Oberseite des Rahmens zum Boden des Rahmens erstrecken;
eine Fronttür (138-1) des Rahmens, die von der Vorderseite (137-1) des Rahmens versetzt ist; und
eine Hintertür (138-2) des Rahmens, die von der Rückseite (137-2) des Rahmens versetzt ist.

11. Verfahren (102) zum Kühlen von elektronischen Komponenten, die in einem Elektronik-Rack untergebracht sind, umfassend:
Bereitstellen eines Rahmens mit einer Vielzahl von Trennwänden (108-1, 108-2) innerhalb des elektronischen Racks, die eine Vielzahl von Abschnitten innerhalb des elektronischen Racks definieren, wobei der Rahmen eine Vorderseite (137-1) des Rahmens, eine Rückseite (137-2) des Rahmens, eine Oberseite des Rahmens und einen Boden des Rahmens beinhaltet;
Definieren eines ersten Abschnitts (106) mit einer ersten (108-1) der Vielzahl von Trennwänden zur Aufnahme einer ersten Anzahl von elektronischen Komponenten (114-1);
Definieren eines zweiten Abschnitts (104) mit einer zweiten der Vielzahl von Trennwänden (108-1, 108-2) zur Aufnahme einer zweiten Anzahl von elektronischen Komponenten, wobei:
die erste der Vielzahl von Trennwänden und die zweite der Vielzahl von Trennwänden (108-1, 108-2) an der Oberseite des Rahmens und am Boden des Rahmens befestigt werden und die erste der Vielzahl von Trennwänden und die zweite der Vielzahl von Trennwänden (108-1, 108-2) sich nicht von der Vorderseite des Rahmens zur Rückseite des Rahmens erstrecken;
Definieren eines dritten Abschnitts zwischen dem ersten Abschnitt und dem zweiten Abschnitt, der eine Anzahl von Kühlsystemen zum Kühlen der ersten Anzahl von elektronischen Komponenten und der zweiten Anzahl von elektronischen Komponenten durch Wärmeübertragung durch die erste der Vielzahl von Trennwänden (108-1) und die zweite der Vielzahl von Trennwänden (108-2) beinhaltet, wobei:
die Vorderseite des Rahmens eine Vorderseite des ersten Abschnitts, eine Vorderseite des zweiten Abschnitts und eine Vorderseite des dritten Abschnitts beinhaltet; und
der dritte Abschnitt verschiedene Arten von Kühlsystemen trägt, um die Kühlleistung entsprechend dem Kühlbedarf der ersten Anzahl von elektronischen Komponenten und der zweiten Anzahl von elektronischen Komponenten anzupassen;
wobei die Vielzahl von Trennwänden beweglich ist, um ein Volumen einiger Abschnitte des ersten, zweiten und dritten Abschnitts zu vergrößern und ein Volumen anderer Abschnitte des ersten, zweiten und dritten Abschnitts zu verkleinern, und wobei die Vielzahl von Trennwänden dazu konfiguriert ist, als leitende Kühlungsempfänger zu fungieren, die Wärme von den Elektronikabschnitten aufnehmen und die aufgenommene Wärme von den Trennwänden wegleiten.

## Revendications

1. Système de refroidissement de rack, comprenant :
un cadre comprenant un certain nombre d'éléments de séparation (108-1, 108-2) à l'intérieur du rack, lesquels définissent une pluralité de sections à l'intérieur du rack, la pluralité de sections comprenant :
un certain nombre de sections électroniques (104, 106) comprenant au moins un premier nombre de composants électroniques ; et
le système de refroidissement de rack étant **caractérisé par** un certain nombre de sections de refroidissement (112) comprenant au moins un premier système de refroidissement configuré pour refroidir au moins le premier nombre de composants électroniques par transfert de chaleur à travers le nombre d'éléments de séparation ;
les éléments de séparation pouvant être déplacés pour augmenter le volume de certaines sections de la pluralité de sections et pour diminuer le volume d'autres sections de la pluralité de sections, et les éléments de séparation étant configurés pour fonctionner comme des récepteurs de refroidissement par conduction qui reçoivent de la chaleur provenant des sections électroniques, et pour évacuer la chaleur reçue des éléments de séparation.

2. Système selon la revendication 1, dans lequel le premier système de refroidissement comprend un système de refroidissement par air/eau et/ou un système de refroidissement de déconnexion à sec.

3. Système selon la revendication 1, dans lequel le nombre d'éléments de séparation comprend :
un premier élément de séparation (108-1) qui définit une première section électronique (106) parmi le nombre de sections électroniques (104, 106) comprenant le premier nombre de composants électroniques (114-1) ;
un second élément de séparation (108-2) qui définit une deuxième section électronique (104) parmi le nombre de sections électroniques (104, 106) comprenant un second nombre de composants électroniques (114-2) ; et
une première section de refroidissement (112) parmi le nombre de sections de refroidissement, entre la première section électronique (106) et la deuxième section électronique (104), comprenant le premier système de refroidissement configuré pour refroidir le premier nombre de composants électroniques (114-1) et le second nombre de composants électroniques (114-2) par transfert de chaleur à travers le premier élément de séparation (108-1) et le second élément de séparation (108-2).

4. Système selon la revendication 3, dans lequel un premier nombre de récepteurs de refroidissement est monté sur le premier élément de séparation (108-1), et un second nombre de récepteurs de refroidissement est monté sur le second élément de séparation (108-2), le premier nombre de récepteurs de refroidissement étant refroidi par déplacement de liquide à travers la première section de refroidissement (112), et le second nombre de récepteurs de refroidissement étant refroidi par déplacement de liquide à travers la première section de refroidissement (112).

5. Système selon la revendication 3, dans lequel un premier nombre de récepteurs de refroidissement est monté sur le premier élément de séparation (108-1), et un second nombre de récepteurs de refroidissement est monté sur le second élément de séparation (108-2), le premier nombre de récepteurs de refroidissement étant refroidi par déplacement d'air à travers la première section de refroidissement (112), et le second nombre de récepteurs de refroidissement étant refroidi par déplacement d'air à travers la première section de refroidissement (112).

6. Système selon la revendication 3, dans lequel un premier nombre de récepteurs de refroidissement est monté sur le premier élément de séparation (108-1), et un second nombre de récepteurs de refroidissement est monté sur le second élément de séparation (108-2), et dans lequel un premier groupe du premier nombre de récepteurs de refroidissement et d'un premier groupe du second nombre de récepteurs de refroidissement sont refroidis par déplacement d'air à travers une première partie de la première section de refroidissement (112), et un second groupe du premier nombre de récepteurs de refroidissement et un second groupe du second nombre de récepteurs de refroidissement sont refroidis par déplacement de liquide à travers une seconde partie de la première section de refroidissement (112).

7. Système selon la revendication 3, dans lequel la première section électronique (106) comprend un deuxième système de refroidissement et la deuxième section électronique (104) comprend un troisième système de refroidissement, le deuxième système de refroidissement et le troisième système de refroidissement étant configurés pour faire circuler de l'air dans la première section de refroidissement (112), et le premier système de refroidissement étant configuré pour faire circuler de l'air dans la première section électronique (106) et la deuxième section électronique (104).

8. Système selon la revendication 3, dans lequel le cadre est configuré pour supporter une pluralité de positions d'au moins un élément de séparation du nombre d'éléments de séparation (108-1, 108-2) de façon à régler le volume du nombre de sections électroniques (106, 104) et/ou du nombre de sections de refroidissement (112).

9. Système selon la revendication 3, dans lequel la première section de refroidissement (112) est configurée pour prendre en charge différents types de systèmes de refroidissement de façon à ajuster la capacité de refroidissement en fonction des besoins de refroidissement du premier nombre de composants électroniques (114-1) et du second nombre de composants électroniques (114-2).

10. Système selon la revendication 3, comprenant en outre :
une partie avant (137-1) du cadre à travers laquelle le premier nombre de composants électroniques (114-1) et le second nombre de composants électroniques (114-2) sont insérés dans le cadre, la partie avant (137-1) du cadre comprenant une partie avant de la première section électronique (114-1), une partie avant de la deuxième section électronique (114-2) et une partie avant de la première section de refroidissement (112) ;
une partie arrière (138-2) du de cadre, le premier élément de séparation (108-1) et le second élément de séparation (108-2) s'étendant de la partie avant (137-1) du cadre à la partie arrière (137-2) du cadre ;
un sommet du cadre ;
un fond du cadre, le premier élément de séparation (108-1) et le second élément de séparation (108-2) étant composés de panneaux solides qui s'étendent du sommet du cadre au fond du cadre ;
une porte avant (138-1) du cadre décalée par rapport à la partie avant (137-1) du cadre ; et
une porte arrière (138-2) du cadre décalée par rapport à la partie arrière (137-2) du cadre.

11. Procédé (102) de refroidissement de composants électroniques logés dans un rack électronique, consistant à :
fournir un cadre comprenant une pluralité d'éléments de séparation (108-1, 108-2) à l'intérieur du rack électronique, lesquels éléments de séparation définissent une pluralité de sections à l'intérieur du rack électronique, le cadre comprenant une partie avant (137-1) du cadre, une partie arrière (137-2) du cadre, un sommet du cadre et un fond du cadre ;
définir une première section (106) avec un premier élément de séparation (108-1) de la pluralité d'éléments de séparation pour loger un premier nombre de composants électroniques (114-1) ;
définir une deuxième section (104) avec un second élément de séparation de la pluralité d'éléments de séparation (108-1, 108-2) pour loger un second nombre de composants électroniques :
le premier élément de séparation de la pluralité d'éléments de séparation et le second élément de séparation de la pluralité d'éléments de séparation (108-1, 108-2) étant fixés au sommet du cadre et au fond du cadre, et le premier élément de séparation de la pluralité d'éléments de séparation et le second élément de séparation de la pluralité d'éléments de séparation (108-1, 108-2) ne s'étendant pas de la partie avant du cadre à la partie arrière du cadre ;
définir une troisième section, entre la première section et la deuxième section, comprenant un certain nombre de systèmes de refroidissement pour refroidir le premier nombre de composants électroniques et le second nombre de composants électroniques par transfert de chaleur à travers le premier élément de séparation de la pluralité d'éléments de séparation (108-1) et le second élément de séparation de la pluralité d'éléments de séparation (108-2) :
la partie avant du cadre comprenant une partie avant de la première section, une partie avant de la deuxième section et une partie avant de la troisième section ; et
la troisième section prenant en charge différents types de systèmes de refroidissement de façon à ajuster la capacité de refroidissement en fonction des besoins de refroidissement du premier nombre de composants électroniques et du second nombre de composants électroniques ;
la pluralité d'éléments de séparation pouvant être déplacés pour augmenter le volume de certaines sections de la première, de la deuxième et de la troisième sections et pour réduire le volume d'autres sections de la première, de la deuxième et de la troisième sections, et les éléments de séparation étant configurés pour fonctionner comme des récepteurs de refroidissement par conduction qui reçoivent de la chaleur provenant des sections électroniques, et pour évacuer la chaleur reçue des éléments de séparation.
